(19) Europäisches Patentamt
European Patent Office
Office européen des brevets

(11) **EP 2 945 012 A1**

(12) **EUROPEAN PATENT APPLICATION**

(43) Date of publication:
**18.11.2015 Bulletin 2015/47**

(51) Int Cl.:
*G02F 1/01* (2006.01)    *H01S 5/40* (2006.01)
*H01S 5/068* (2006.01)    *H01S 3/13* (2006.01)
*H01S 3/23* (2006.01)    *H01S 3/11* (2006.01)
*H01S 5/12* (2006.01)    *H01S 3/00* (2006.01)
*H01S 5/00* (2006.01)    *H01S 3/067* (2006.01)
*H01S 3/06* (2006.01)

(21) Application number: **15174389.5**

(22) Date of filing: **06.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.09.2010 JP 2010199276**
**06.09.2010 JP 2010199266**

(62) Document number(s) of the earlier application(s) in accordance with Art. 76 EPC:
**11823580.3 / 2 615 488**

(71) Applicants:
- **OSAKA UNIVERSITY**
  **Suita-shi, Osaka 565-0871 (JP)**
- **HAMAMATSU PHOTONICS K.K.**
  **Hamamatsu-shi**
  **Shizuoka 435-8558 (JP)**

(72) Inventors:
- **MIYANAGA, Noriaki**
  **Suita-shi, Osaka 565-0871 (JP)**
- **FUJITA, Masayuki**
  **Osaka-shi, Osaka 550-0004 (JP)**
- **KURITA, Takashi**
  **Hamamatsu-shi, Shizuoka 435-8558 (JP)**
- **KAWASHIMA, Toshiyuki**
  **Hamamatsu-shi, Shizuoka 435-8558 (JP)**

(74) Representative: **Boult Wade Tennant**
**Verulam Gardens**
**70 Gray's Inn Road**
**London WC1X 8BT (GB)**

Remarks:
This application was filed on 29-06-2015 as a divisional application to the application mentioned under INID code 62.

(54) **LASER DEVICE**

(57) A laser device (1) including a plurality of oscillating means (10) for oscillating a plurality of laser lights (L1) being continuous lights and having frequencies different from each other, respectively, multiplexing means (13) for multiplexing, after amplifying or without amplifying, the respective laser lights oscillated from the respective oscillating means at a predetermined position to generate a multiplexed light (L2), and phase control means (20) for controlling the phase of each of the laser lights so that a peak in output of the multiplexed light repeatedly appears at predetermined time intervals at the predetermined position so that the same pulse temporal waveform repeatedly appears at predetermined time intervals. The laser device may comprise DFB laser diodes (10) and a grating (13) for wavelength multiplexing and temperature controlled fiber segments as phase control means (20), the control comprising detection of beat signals and a feedback loop for phase stabilisation.

**Fig.2**

## Description

### Technical Field

The present invention relates to a laser device for generating pulsed laser light.

### Background Art

As a laser device in the above-described technical field, for example, a mode-locked laser device described in Patent Document 1 is known. The mode-locked laser device described in Patent Document 1 generates pulsed laser lights in a plurality of wavelength regions at one time by amplifying a laser light modulated at a frequency that is integral times the resonator longitudinal mode interval by a plurality of amplifiers (such as optical fiber amplifiers) having gains in spectral regions of mutually different center frequencies, that is, center wavelengths.

### Citation List

### Patent Literature

Patent Document 1: Japanese Patent Application Laid-Open No. H06-90050

### Summary of Invention

### Technical Problem

Meanwhile, a pulsed laser light has a greater peak light intensity than that of a continuous light equivalent in energy per unit time, that is, average power. Therefore, in the case of amplifying a pulsed laser light, for the purpose of preventing damage to the amplifier, it is necessary to increase its pulse width to lower the peak light intensity or to limit the amplification factor. Therefore, it is difficult for a laser device that amplifies a pulsed laser light to generate a high-output pulsed laser light.

The present invention has been made in view of such circumstances, and an object thereof is to provide a laser device capable of easily generating a short-pulse and high-output pulsed laser light and a laser device capable of generating a high-output pulsed laser light.

### Solution to Problem

An aspect of the present invention relates to a laser device. This laser device is characterized by including a plurality of oscillating means for oscillating a plurality of laser lights being continuous lights and having frequencies different from each other, respectively, a multiplexing means for multiplexing the respective laser lights oscillated from the respective oscillating means at a predetermined position to generate a multiplexed light, and a phase control means for controlling the phase of each of the laser lights so that a peak in output of the multiplexed light repeatedly appears at predetermined time intervals at the predetermined position.

In this laser device, when generating a multiplexed light by multiplexing a plurality of laser lights having frequencies different from each other at a predetermined position, the phase of each of the laser lights is controlled so that a peak in output of the multiplexed light repeatedly appears at predetermined time intervals at the predetermined position. A pulsed laser light is hence generated at the predetermined position. Thus, in this laser device, a plurality of respective laser lights are multiplexed to generate a pulsed laser light. Therefore, by increasing the number of oscillating means (that is, the number of laser lights having frequencies different from each other), a short-pulse and high-output pulsed laser light can be easily generated.

Moreover, the respective oscillating means can oscillate the laser lights having frequencies different from each other with substantially constant frequency differences, respectively. In this case, because the frequency difference between the laser lights to be oscillated from the oscillating means is substantially constant, it becomes easy to control the phase of each of the laser lights so that a peak in output of the multiplexed light repeatedly appears at predetermined time intervals. Therefore, a short-pulse and high-output pulsed laser light can be more easily generated.

Moreover, the oscillating means can be a semiconductor laser. In this case, a small-sized and lightweight laser device with low power consumption can be realized. Moreover, the mechanical stability of the laser device can be improved. Furthermore, the manufacturing cost of the laser device can be reduced.

Further, each of the oscillating means can be connected with an optical fiber through which each of the laser lights propagates, and the phase control means can control the phase of each of the laser lights by controlling the temperature of each of the optical fibers. In this case, by controlling the temperature of the optical fiber, the phase of each of the laser lights can be easily controlled.

Here, another aspect of the present invention relates to a laser device. This laser device is characterized by including an oscillating means for oscillating a laser pulse train consisting of a plurality of continuous laser lights having frequencies different from each other, a demultiplexing means for demultiplexing the laser pulse train oscillated from the oscillating means into the plurality of continuous laser lights having frequencies different from each other, an amplifying means for amplifying each of the continuous laser lights demultiplexed by the demultiplexing means, a multiplexing means for multiplexing the respective continuous laser lights amplified by the amplifying means at a predetermined position to generate a multiplexed light, and a phase control means for controlling the phase of each of the continuous laser lights so that a peak in output of the multiplexed light repeatedly appears at predetermined time intervals at the predetermined position.

In this laser device, the amplifying means amplifies each of the plurality of continuous laser lights. Therefore, as compared with the case of amplifying a pulsed laser light, the amplification factor can be set high. Moreover, when generating a multiplexed light by multiplexing at a predetermined position the respective continuous laser lights amplified as such, the phase of each of the continuous laser lights is controlled so that a peak in output of the multiplexed light repeatedly appears at predetermined time intervals at the predetermined position. A pulsed laser light is hence generated by the amplified plurality of continuous laser lights at the predetermined position. Accordingly, this laser device allows generating a high-output pulsed laser light.

Here, the oscillating means can oscillate the laser pulse train consisting of the continuous laser lights having frequencies different from each other with substantially constant frequency differences. In this case, controlling the phase of each of the continuous laser lights having frequencies different from each other makes it easy that a peak in output of the multiplexed light repeatedly appears at predetermined time intervals. Therefore, a high-output pulsed laser light can be easily generated.

Moreover, this laser device can further include a frequency difference adjusting means for adjusting a frequency difference between the continuous laser lights composing the laser pulse train oscillated from the oscillating means. In this case, the pulse repetition rate of a pulsed laser light to be generated can be adjusted by adjusting the frequency difference between the continuous laser lights.

Moreover, the oscillating means can be a mode-locked oscillator or a semiconductor laser for a high-speed current modulation. In this case, a small-sized and lightweight laser device with low power consumption can be realized. Moreover, the mechanical stability of the laser device can be improved. Furthermore, the manufacturing cost of the laser device can be reduced.

Further, the amplifying means can be a fiber array containing a plurality of optical fibers or a slab type solid-state laser amplifier, which propagates while amplifying each of the continuous laser lights demultiplexed by the demultiplexing means, and the phase control means can measure a spectral phase of the multiplexed light as well as control the phase of each of the continuous laser lights based on a result of the measurement. In this case, the phase of each of the continuous laser lights having frequencies different from each other can be easily controlled by, for example, providing a spectral phase modulator at a previous stage of the demultiplexing means.

**Advantageous Effects of Invention**

According to the present invention, a laser device capable of easily generating a short-pulse and high-output pulsed laser light and a laser device capable of generating a high-output pulsed laser light can be provided. Further aspects of the present disclosure as set forth in the following numbered clauses:

Clause 1. A laser device comprising:

a plurality of oscillating means for oscillating a plurality of laser lights being continuous lights and having frequencies different from each other, respectively;
multiplexing means for multiplexing the respective laser lights oscillated from the respective oscillating means at a predetermined position to generate a multiplexed light; and
phase control means for controlling the phase of each of the laser lights so that a peak in output of the multiplexed light repeatedly appears at predetermined time intervals at the predetermined position.

Clause 2. The laser device according to clause 1, wherein the respective oscillating means oscillate the laser lights having frequencies different from each other with substantially constant frequency differences, respectively.
Clause 3. The laser device according to clause 1 or 2, wherein the oscillating means is a semiconductor laser.
Clause 4. The laser device according to any one of clauses 1 to 3, wherein each of the oscillating means is connected with an optical fiber through which each of the laser lights propagates, and

the phase control means controls the phase of each of the laser lights by controlling the temperature of each of the optical fibers.

Clause 5. A laser device comprising:

oscillating means for oscillating a laser pulse train consisting of a plurality of continuous laser lights having frequencies different from each other;

demultiplexing means for demultiplexing the laser pulse train oscillated from the oscillating means into the plurality of continuous laser lights having frequencies different from each other;

amplifying means for amplifying each of the continuous laser lights demultiplexed by the demultiplexing means;

multiplexing means for multiplexing the respective continuous laser lights amplified by the amplifying means at a predetermined position to generate a multiplexed light; and

phase control means for controlling the phase of each of the continuous laser lights so that a peak in output of the multiplexed light repeatedly appears at predetermined time intervals at the predetermined position.

Clause 6. The laser device according to clause 5, wherein the oscillating means oscillates the laser pulse train consisting of the continuous laser lights having frequencies different from each other with substantially constant frequency differences.

Clause 7. The laser device according to clause 6, further comprising frequency difference adjusting means for adjusting a frequency difference between the continuous laser lights composing the laser pulse train oscillated from the oscillating means.

Clause 8. The laser device according to any one of clauses 5 to 7, wherein the oscillating means is a mode-locked oscillator or a semiconductor laser for a high-speed current modulation.

Clause 9. The laser device according to any one of clauses 5 to 8, wherein the amplifying means is a fiber array containing a plurality of optical fibers or a slab type solid-state laser amplifier, which propagates while amplifying each of the continuous laser lights demultiplexed by the demultiplexing means, and

the phase control means measures a spectral phase of the multiplexed light as well as controls the phase of each of the continuous laser lights based on a result of the measurement.

## Brief Description of Drawings

Fig. 1 is a graph for explaining an optical frequency comb. Fig. 2 is a configuration diagram of a laser device according to a first embodiment of the present invention.

Fig. 3 is a configuration diagram of the phase control device shown in Fig. 2.

Figs. 4 are partially enlarged views each showing a heater of the phase control unit shown in Fig. 3.

Fig. 5 is a graph showing an output temporal waveform of the multiplexed light shown in Fig. 2.

Fig. 6 is a configuration diagram of a variation of the laser device shown in Fig. 2.

Fig. 7 is a graph for explaining an optical frequency comb.

Fig. 8 is a configuration diagram of a laser device according to a second embodiment of the present invention.

Fig. 9 is a partially enlarged view of the laser device shown in Fig. 8.

Fig. 10 is a partial sectional view showing a configuration of the channel amplifier shown in Fig. 8.

Fig. 11 is a view for explaining the operation of a frequency modulator.

Fig. 12 is a configuration diagram of a laser device according to a third embodiment of the present invention.

Fig. 13 is a perspective view showing a configuration of the slab type solid-state laser amplifier shown in Fig. 12.

Fig. 14 is a configuration view of a variation of the laser device shown in Fig. 12.

Figs. 15 are graphs showing states of adjustment of the pulse output waveform.

## Description of Embodiments

Hereinafter, embodiments of the present invention will be described in detail with reference to the drawings. In the respective figures, the same or corresponding parts are denoted by the same reference signs, and overlapping description will be omitted

[First embodiment]

A laser device according to the present embodiment generates a pulsed layer light that is equivalent to laser lights oscillated from a mode-locked laser that realizes an optical frequency comb. Now, the optical frequency comb and mode-locked oscillation will be described.

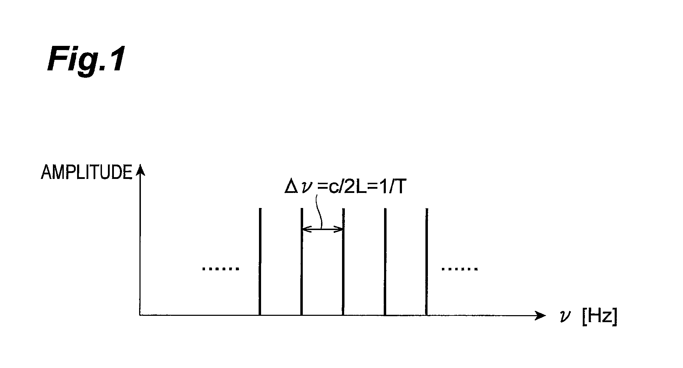

For example, in a Fabry-Perot resonator, a plurality of longitudinal mode laser lights exist. The frequencies of the respective longitudinal mode laser lights are, where the resonator length is provided as L, as shown in Fig. 1, arrayed on the frequency axis at intervals of $\Delta v=c/2L$ (c denotes light speed). A state in which the frequencies of respective laser lights are arrayed at equal intervals as such is called an optical frequency comb. In a laser light source including such a resonator, if phase modulation is not performed for the respective laser lights, because the phase relationship between the laser lights is random, an output light of the laser light source which is a multiplexed light of those laser lights also has a random output temporal waveform. On the other hand, by performing, in such a laser light source, by means of a saturable absorber element and an optical modulator, phase modulation of the respective laser lights so that the phases of the laser lights are aligned with each other, the output temporal waveform of an output light has a pulse shape with a repetition period of T ($T=1/\Delta v$), and mode-locked oscillation is obtained.

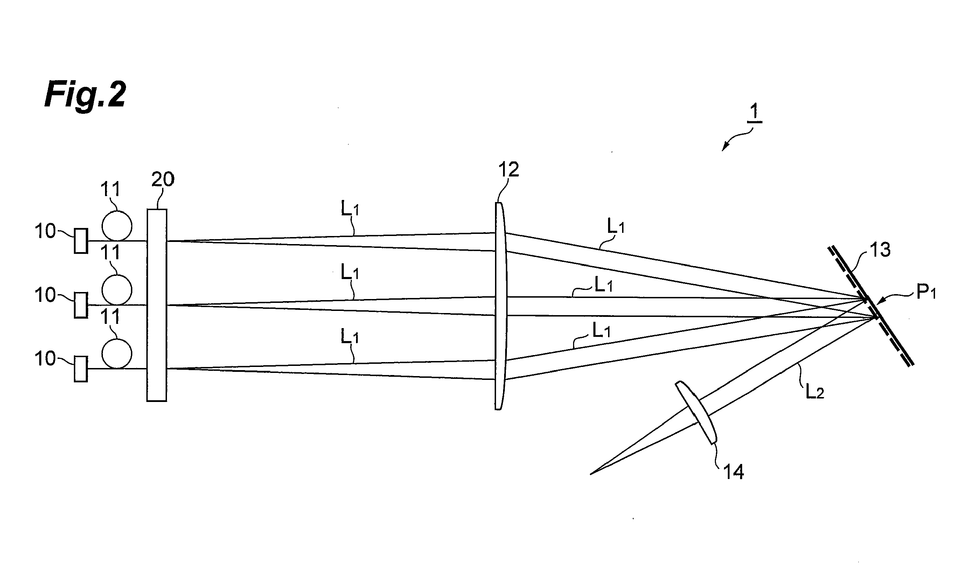

As shown in Fig. 2, the laser device 1 according to the present embodiment includes a plurality of (here, three) laser light sources (oscillating means) 10 that oscillate, respectively, a plurality of laser lights $L_1$ being continuous lights and having frequencies different from each other with constant frequency differences as in the optical frequency comb mentioned above. The respective laser light sources 10 can be provided as, for example, distributed feedback type semiconductor lasers (DFB semiconductor lasers) having oscillation wavelengths that are different by 0.1nm from each other. In the present embodiment, a continuous light means a laser light the output of which is substantially constant with respect to time, while a pulsed laser light means a laser light a peak in output of which repeatedly appears at predetermined time intervals.

The laser device 1 further includes an optical fiber 11 which is connected to each of the laser light sources 10 and through which each of the laser lights $L_1$ oscillated from the laser light sources 10 propagates, and a lens (multiplexing means) 12 disposed on the optical path of the laser light $L_1$ emitted from the optical fiber 11, and a diffraction grating (multiplexing means) 13 onto which each of the laser lights $L_1$ passed through the lens 12 is made incident.

The lens 12 is disposed at a position separated by its focal length from an emitting end of the optical fiber 11. The diffraction grating 13 is disposed at a position separated from the lens 12 by a focal length of the lens 12. Therefore, each of the laser lights $L_1$ emitted from the optical fibers 11 becomes a parallel beam as a result of passing through the lens 12, and is converged to a converging position $P_1$ of the diffraction grating 13. The diffraction grating 13 multiplexes the laser lights $L_1$ at the converging position $P_1$ to generate a multiplexed light $L_2$.

Here, the laser device 1 further includes a phase control device (phase control means) 20. The phase control device 20 controls the phase of each of the laser lights $L_1$ so that a peak in output of the multiplexed light $L_2$ repeatedly appears at predetermined time intervals (so that the same pulse temporal waveform repeatedly appears at predetermined time intervals) at the converging position $P_1$ of the diffraction grating 13. This phase control will be specifically described.

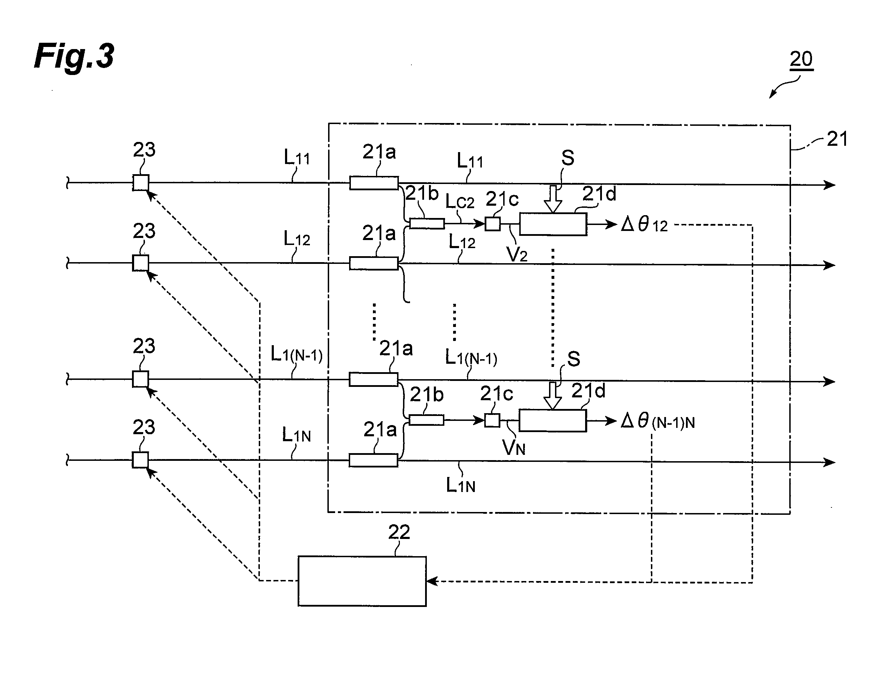

As shown in Fig. 3, the phase control device 20 has a phase difference detecting unit 21, a signal control unit 22, and a phase control unit 23. The phase difference detecting unit 21, by using optical heterodyne interferometry, detects a phase difference between laser lights $L_1$ respectively having frequencies adjacent to each other on the frequency axis (hereinafter, simply referred to as "adjacent laser lights") out of the laser lights $L_1$ emitted from the laser light source 10, and sends information indicating the detection result to the signal control unit 22.

More specifically, in the phase difference detecting unit 21, each of the mutually adjacent laser light $L_{11}$ and laser light $L_{12}$ out of the laser lights $L_1$ is split by an optical coupler 21a, and then the split laser lights are coupled with each other by an optical coupler 21b. Subsequently, the laser light $L_{c2}$ coupled by the optical coupler 21b is converted into an electrical signal $V_2$ by, for example, a photodetector 21c such as a photodiode. The laser light $L_{11}$ is expressed, by means of an angular frequency $\omega_1$ and a phase $\phi_1$, as follows:

[Numerical formula 1]

$$E_1(t) = A_1 \exp[i\omega_1 t + i\phi_1],$$

and the laser light $L_{12}$ is expressed, by means of an angular frequency $\omega_2$ and a phase $\phi_2$, as follows:

[Numerical formula 2]

$$E_2(t) = A_2 \exp[i\omega_2 t + i\phi_2].$$

Here, where an angular frequency difference $\Delta\omega$ between the laser light $L_{11}$ and the laser light $L_{12}$ is provided as $\omega_1-\omega_2$

and a phase difference $\Delta\theta_{12}$ is provided as $\phi_1-\phi_2$, the above-described $E_2(t)$ can be expressed as follows:

[Numerical formula 3]

$$E_2(t) = A_2 \exp\left[i(\omega_1 + \Delta\omega)t + i\{\phi_1 + \Delta\theta_{12}\}\right].$$

Accordingly, the electrical signal $V_2(t)$ to be generated by the photodetector 21c results in a beat signal having the angular frequency difference $\Delta\omega$ and the phase difference $\Delta\theta_{12}$ such as follows:

[Numerical formula 4]

$$V_2(t) = K\left[|A_1|^2 + |A_2|^2 + 2|A_1||A_2|\cos[\Delta\omega t + \Delta\theta_{12}]\right].$$

Then, by obtaining exclusive OR between the electrical signal $V_2(t)$ and a clock signal S having the angular frequency difference $\Delta\omega$ by a phase meter 21d, the phase difference $\Delta\theta_{12}$ between the laser light $L_{11}$ and the laser light $L_{12}$ can be determined. Similarly, because a laser light $L_{1N}$ is expressed as follows:

[Numerical formula 5]

$$E_N(t) = A_N \exp\left[i\omega_N t + i\phi_N\right],$$

an electrical signal $V_N(t)$ to be generated from an adjacent laser light $L_{1(N-1)}$ and laser light $L_{1N}$ is as follows:

[Numerical formula 6]

$$V_N(t) = K\left[|A_{N-1}|^2 + |A_N|^2 + 2|A_{N-1}||A_N|\cos[\Delta\omega t + \Delta\theta_{(N-1)N}]\right].$$

Here, N means the N-th laser light $L_{1N}$. Therefore, by obtaining exclusive OR between the electrical signal $V_N(t)$ and a clock signal S, a phase difference $\Delta\theta_{(N-1)N}$ between the laser light $L_{1(N-1)}$ and the laser light $L_{1N}$ can be determined. By thus performing the above-described processing to all of the laser lights $L_1$, phase differences between all adjacent laser lights $L_1$ can be obtained.

The signal control unit 22, based on the information indicating a phase difference between adjacent laser lights $L_1$ obtained in such a manner as described above, determines such phase control amounts of the respective laser lights $L_1$ so as to make the phases of the laser lights $L_1$ identical, and sends information indicating the determined control amount to each of the phase control units 23. Each of the phase control units 23 controls the phase of each of the laser lights $L_1$ based on the information indicating the control amount transmitted from the signal control unit 22.

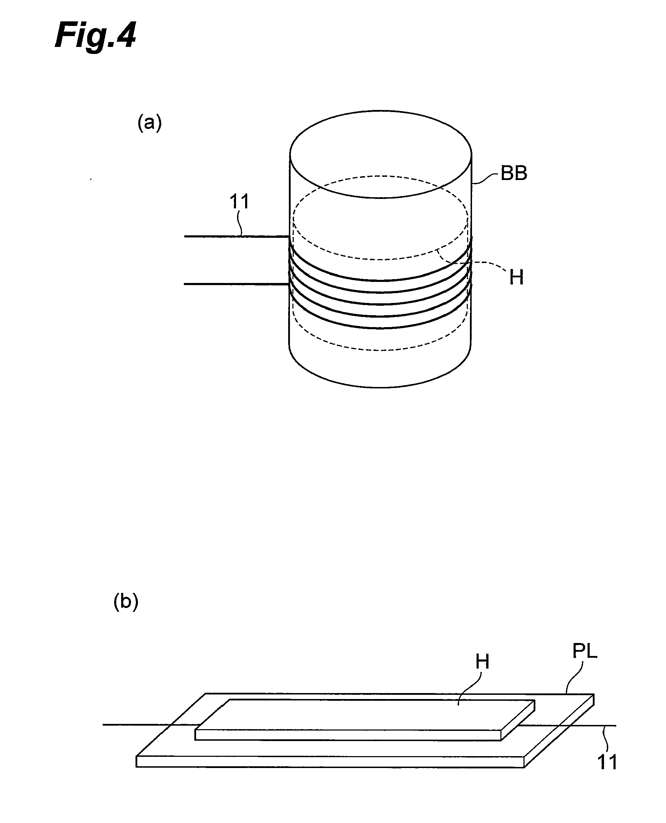

The phase control unit 23 is provided for each of the optical fibers 11. The phase control unit 23, for example, as shown in Fig. 4(a), has a bobbin BB with a built-in heater H. In this case, each of the optical fibers 11 is wound around the bobbin BB. Alternatively, the phase control unit 23, for example, as shown in Fig. 4(b), has a plate member PL on which a heater H is placed. In this case, each of the optical fibers 11 is disposed between the plate member PL and the heater H. Each phase control unit 23, based on the information indicating the control amount transmitted from the signal control unit 22, controls the calorific value of each heater H to adjust the temperature of each optical fiber 11 so as to adjust the optical path length of the laser light $L_1$ that propagates through each optical fiber 11.

In actuality, for example, when the optical fiber 11 is a silica fiber, its optical path length has a temperature coefficient of 28.8 $\mu$m/(mk) (refer to (Opt. Laser Technol. 37, 29-32 (2004)), so that the temperature coefficient becomes 27 $\lambda$/(mk) where the center wavelength of a predetermined laser light $L_1$ is provided as 1.064 $\mu$m. Therefore, by suitably selecting the length of a part to adjust the temperature of the optical fiber 11 and the amount to adjust the temperature, an adjustment of the optical path length on the level of $\lambda$/100 is enabled.

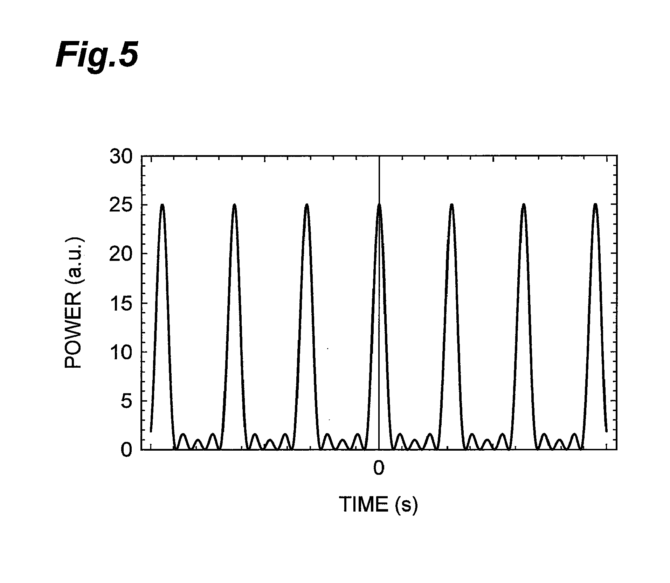

As a result of the phase control device 20 controlling the phases of the laser lights $L_1$ as such, the multiplexed

light $L_2$ to be generated by the diffraction grating 13, as shown in Fig. 5, results in a pulsed laser light equivalent to optical frequency comb laser lights after mode-locked oscillation. The multiplexed light $L_2$ generated by the diffraction grating 13 is converged to a predetermined position by a lens 14.

In the laser device 1 configured as in the above, first, a laser light $L_1$ being a continuous light is oscillated from each of the laser light sources 10. Each of the laser lights $L_1$ oscillated from the laser light sources 10 propagates through each of the optical fibers 11. The respective laser lights $L_1$ propagating through the respective optical fibers 11 are made identical in phase with each other at the multiplexing position $P_1$ by the phase control device 20. Each of the laser lights $L_1$ made identical in phase, after being emitted from the optical fiber 11, is converged onto the diffraction grating 13 by passing through the lens 12. Then, the respective laser lights $L_1$ converged onto the diffraction grating 13 are multiplexed with each other by the diffraction grating 13, and output from the laser device 1 after passing through the lens 14 as a multiplexed light $L_2$ being a pulsed laser light. At this time, the focal length of the lens 12, the groove density of the diffraction grating 13, and the incident angle onto the diffraction grating 13 can be adjusted so that the multiplexed light $L_2$ becomes a parallel beam.

As described above, in the laser device 1 according to the present embodiment, when generating the multiplexed light $L_2$ by multiplexing the respective laser lights $L_1$, the phase of each of the laser lights $L_1$ is controlled so that a peak in output of the multiplexed light $L_2$ repeatedly appears at predetermined time intervals at the converging position $P_1$ of the diffraction grating 13. A pulsed laser light is hence generated at the converging position $P_1$. Thus, in this laser device 1, a plurality of laser lights $L_1$ are multiplexed to generate a pulsed laser light. Therefore, by increasing the number of laser light sources 10 (that is, the number of laser lights $L_1$ having frequencies different from each other), a short-pulse and high-output pulsed laser light can be easily generated.

Moreover, in the laser device 1, the respective laser lights $L_1$ being continuous lights are multiplexed and converted into a laser pulse train. Therefore, a nonlinear optical effect (for example, self-phase modulation, beam breakup, or the like) and a narrower bandwidth (an increase in pulse width) when amplifying a pulsed laser light do not occur. Accordingly, by the laser device 1, a pulsed laser light with high beam quality as well as having a high repetition rate and short pulses can be generated, as compared with that of a laser device that amplifies a pulsed laser light.

Moreover, in the laser device 1, because the frequency difference between the laser lights $L_1$ to be oscillated from the laser light sources 10 is constant, it is easy to control the phase of each of the laser lights $L_1$ so that a peak in output of the multiplexed light $L_2$ repeatedly appears at predetermined time intervals. Therefore, a short-pulse and high-output pulsed laser light can be more easily generated.

Moreover, in the laser device 1, because each of the laser light sources 10 is a semiconductor laser, a small-sized and lightweight laser device with low power consumption can be realized. Moreover, the mechanical stability of the laser device can be improved. Furthermore, the manufacturing cost of the laser device can be reduced.

Further, in the laser device 1, because the phase control device 20 controls the phase of each of the laser lights $L_1$ by controlling the temperature of each of the optical fibers 11, the phase of each of the laser lights $L_1$ can be easily controlled.

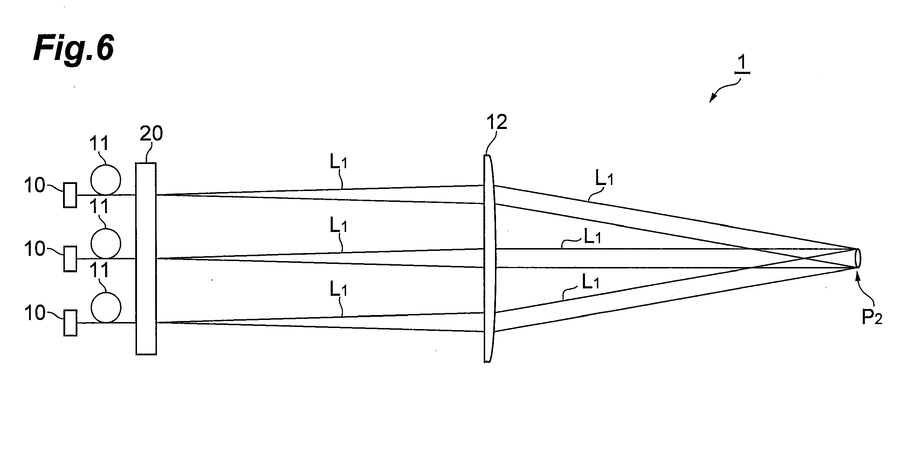

Although the laser device 1 is configured so as to generate a multiplexed light $L_2$ by multiplexing respective laser lights $L_1$ by the diffraction grating 13, when it is not necessary to transmit a multiplexed light $L_2$, for example, as shown in Fig. 6, there may be a configuration for generating a multiplexed light $L_2$ by multiplexing laser lights $L_1$ at a focal position $P_2$ of the lens 12, without using the diffraction grating 13.

Moreover, in the laser device 1, the laser light sources 10 may be either a DFB semiconductor laser array in which DFB semiconductor lasers are one-dimensionally arrayed or a fiber laser array using fiber Bragg diffraction gratings. Particularly, when the laser light sources 10 are provided as a DFB semiconductor laser array, by stacking the DFB semiconductor laser arrays to array oscillation sources of laser lights $L_1$ two-dimensionally, the number of laser lights $L_1$ can be easily increased, so that the laser device 1 can be downsized.

Moreover, the laser device 1 may include an amplifier that amplifies each of the laser lights $L_1$ oscillated from each of the laser light sources 10. That is, in the laser device 1, each of the optical fibers 11 may be replaced with an optical fiber amplifier that propagates while amplifying each of the laser lights $L_1$. In that case, the phase control device 20 controls the phase of each of the laser lights $L_1$ by controlling the temperature of each of the optical fibers in the optical fiber amplifiers.

[Second embodiment]

A laser device according to the present embodiment uses a mode-locked laser that realizes an optical frequency comb as a laser light source. Now, the optical frequency comb and mode-locked oscillation will be described.

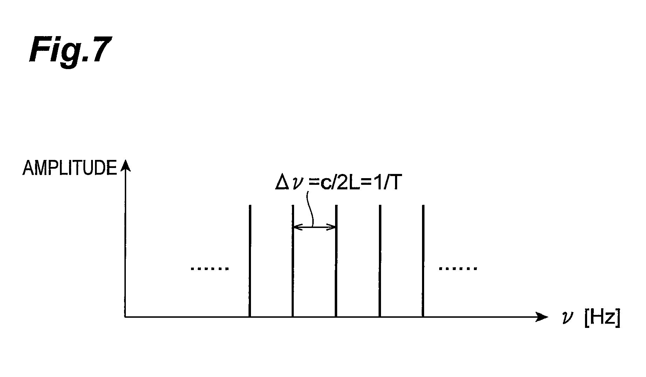

For example, in a Fabry-Perot resonator, a plurality of longitudinal mode laser lights exist. The frequencies of the respective longitudinal mode laser lights are, when the resonator length is provided as L, as shown in Fig. 7, arrayed on the frequency axis at intervals of $\Delta v=c/2L$ (c denotes light speed). A state in which the frequencies of respective laser lights are arrayed at equal intervals as such is called an optical frequency comb. In a laser light source including such a resonator, if phase modulation is not performed for the respective laser lights, because the phase relationship between the laser lights is random, an output light of the laser light source which is a multiplexed light of those laser lights also has a random output temporal waveform. On the other hand, by performing, in such a laser light source, by means of a saturable absorber element and an electro-optical modulator, an acousto-optic modulator, or the like, phase modulation of the respective laser lights so that the phases of the laser lights are aligned with each other, the output temporal waveform of an output light has a pulse shape with a repetition period of T (T=1/$\Delta$v), and mode-locked oscillation is obtained. Such oscillating means may be a light source where a short pulse repeatedly appears at predetermined time intervals, as in a semiconductor laser for high-frequency current modulation.

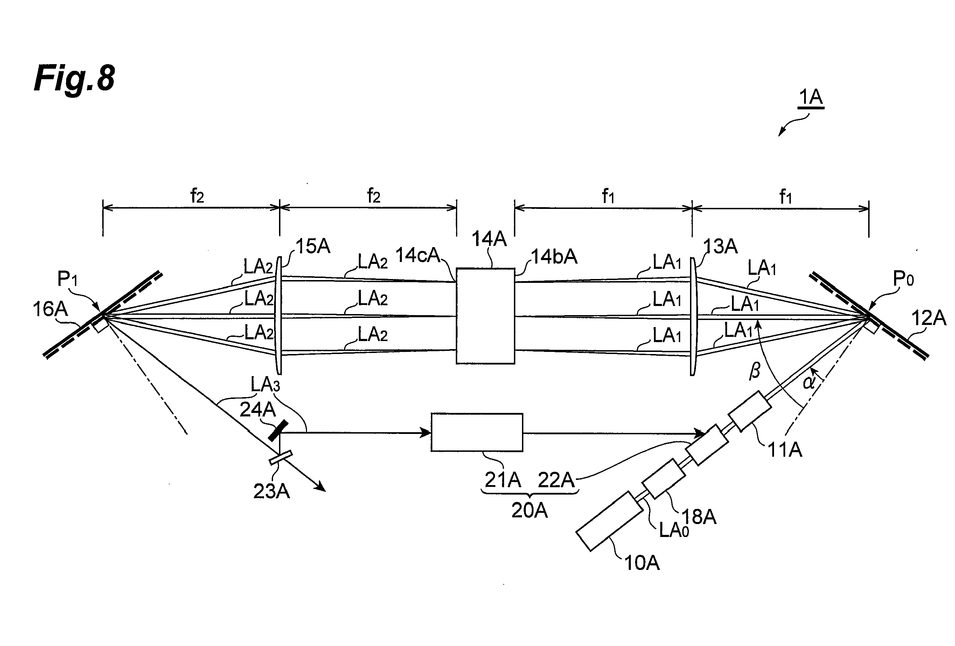

As shown in Fig. 8, the laser device 1A according to the present embodiment includes a laser light source (oscillating means) 10A, such as a mode-locked laser that realizes an optical frequency comb as mentioned above or a semiconductor laser for high-repetition-rate current modulation. A seed light $LA_0$ being an output light of the laser light source 10A is a pulsed light (laser pulse train), and consists of a plurality of continuous laser lights having frequencies different from each other with constant frequency differences and identical in phase with each other. In other words, the laser light source 10A multiplexes a plurality of laser lights being continuous lights and having frequencies different from each other with constant frequency differences, and oscillates the multiplexed light as a seed light $LA_0$ being a pulsed laser light. A continuous light (continuous laser light) mentioned here means such a laser light the output of which is substantially constant with respect to time, while a pulsed laser light means such a laser light a peak in output of which repeatedly appears at predetermined time intervals.

The laser device 1A further includes an optical isolator 11A and a diffraction grating (demultiplexing means) 12A disposed in order on the optical path of the seed light $LA_0$ oscillated from the laser light source 10A. The optical isolator 11A prevents a return light to the laser light source 10A. The diffraction grating 12A demultiplexes by frequency the seed light $LA_0$ into a plurality of (here, three) laser lights $LA_1$ (i.e. it demultiplexes the laser pulse train oscillated from the laser light source 10A into a plurality of continuous laser lights $LA_1$ having frequencies different from each other). In other words, the diffraction grating 12A causes angular dispersion of the optical frequency comb of the seed light $LA_0$. In still other words, the diffraction grating 12A spatially arrays by frequency the plurality of laser lights contained in the seed light $LA_0$. At this time, the respective laser lights $LA_1$ are spatially arrayed in the order of their frequencies.

The laser device 1A further includes a lens 13A disposed on the optical paths of the laser lights $LA_1$ demultiplexed by the diffraction grating 12A. The lens 13A has a focal length of $f_1$, and is disposed at a position separated by the distance $f_1$ from an incident position $P_0$ of the seed light $LA_0$ in the diffraction grating 12A. Therefore, the respective laser lights $LA_1$ demultiplexed by the diffraction grating 12A, as a result of passing through the lens 13A, travel parallel to each other with predetermined intervals $\Delta$x, and are respectively converged at positions of the distance $f_1$ from the lens 13A.

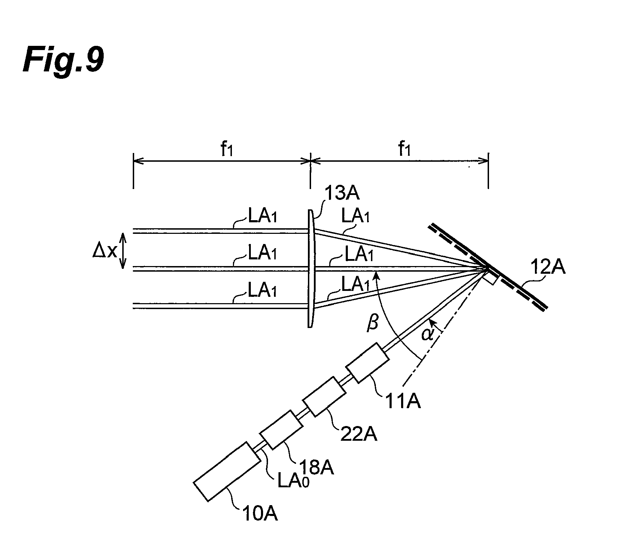

The interval $\Delta$x of the adjacent laser lights $LA_1$ can be determined, for example, as follows. That is, as shown in Fig. 9, where the angle of diffraction in the diffraction grating 12A of a predetermined laser light $LA_1$ having a wavelength $\lambda$ is provided as $\beta$ and where m denotes the order of diffraction (usually, first-order diffraction (m=1) is used), N denotes the number of grooves per 1mm of the diffraction grating 12A, and d denotes the groove spacing (1/N) of the diffraction grating 12A, the angular dispersion d$\beta$/d$\lambda$ of the diffraction grating 12A is expressed as follows:

[Numerical formula 7]

$$\frac{d\beta}{d\lambda} = \frac{mN}{\cos\beta} = \frac{m}{d\cos\beta}.$$

Moreover, the reciprocal linear dispersion d$\lambda$/dx is expressed as follows:

[Numerical formula 8]

$$\frac{d\lambda}{dx} = \frac{d\cos\beta}{m \cdot f_1}.$$

Therefore, where the wavelength interval between the adjacent laser lights $LA_1$ is provided as $\Delta\lambda$, the interval $\Delta$x between the adjacent laser lights $LA_1$ can be determined as follows:

## [Numerical formula 9]

$$\Delta x = \frac{dx}{d\lambda}\Delta\lambda = \frac{m \cdot f_1}{d\cos\beta}\Delta\lambda$$

Specifically, where the focal length $f_1$ of the lens 13A is 1m, the number of grooves N is 1200g/mm, and the incident angle $\alpha$ of the seed light $LA_0$ with respect to the diffraction grating 12A is 20deg, the angle of diffraction is 68.43deg where the center wavelength is 1060nm. At this time, the interval $\Delta x$ when the wavelength interval $\Delta\lambda$ is 0.375pm, 37.5pm, and 0.375nm results in 1.22$\mu$m, 122$\mu$m, and 1.22mm, respectively.

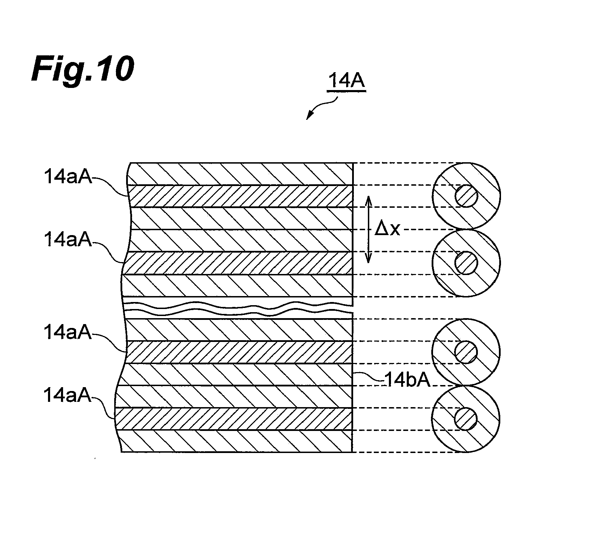

The laser device 1A, as shown in Fig. 8, further includes a channel amplifier (amplifying means) 14A disposed on the optical path of the laser light $LA_1$ passed through the lens 13A. The channel amplifier 14A is made incident with each of the laser lights $LA_1$ passed through the lens 13A, and amplifies each of the incident laser lights $LA_1$ to emit the same as a laser light $LA_2$. The channel amplifier 14A is, as shown in Fig. 10, a fiber array composed of a plurality of optical fibers 14aA doped with an active medium (for example, Nd, Yb, Er, Bi, Pr, and the like) arranged into an array. Therefore, the channel amplifier 14A propagates while amplifying each of the laser lights $LA_1$. In such a channel amplifier 14A, by appropriately selecting a combination of the type of active medium and the oscillation wavelength in the laser light source 10A, laser amplification having a desired center wavelength is enabled.

The channel amplifier 14A is disposed so that its light incident end face 14bA is located at a position separated by the distance $f_1$ from the lens 13A. Therefore, each of the laser lights $LA_1$ demultiplexed by the diffraction grating 12A is, by passing through the lens 13A, converged on the light incident end face 14bA of the channel amplifier 14A. Because the interval $\Delta x$ between the adjacent laser lights $LA_1$ is determined as above, by providing the interval between adjacent cores of the optical fibers 14aA composing the channel amplifier 14A as the same $\Delta x$, one frequency of laser light $LA_1$ can be caused to propagate through one optical fiber 14aA.

The laser device 1A, as shown in Fig. 8, further includes a lens (multiplexing means) 15A and a diffraction grating (multiplexing means) 16A disposed in order on the optical path of the laser light $LA_2$ emitted from the channel amplifier 14A. The lens 15A has a focal length of $f_2$, and is disposed at a position separated by the distance $f_2$ from a light emitting end face 14cA of the channel amplifier 14A. Moreover, the diffraction grating 16A is disposed at a position separated from the lens 15A by the distance $f_2$. Therefore, each of the laser lights $LA_2$ emitted from the channel amplifier 14A is, by passing through the lens 15A, converged to a converging position $P_1$ of the diffraction grating 16A. As a result, the laser lights $LA_2$ emitted from the channel amplifier 14A are multiplexed at the converging position $P_1$ of the diffraction grating 16A, and a multiplexed light $LA_3$ as an output light of the laser device 1A is generated. At this time, by setting the focal length $f_2$ of the lens 15A and the groove density of the diffraction grating 16A to values different from those of the focal length $f_1$ of the lens 13A and the groove density of the diffraction grating 12A, the beam thickness of the multiplexed light $LA_3$ being a parallel beam can be made to have a desired value.

Here, the laser device 1A further includes a phase control device (phase control means) 20A. The phase control device 20A controls the phase of each of the laser lights $LA_1$ so that a peak in output of the multiplexed light $LA_3$ repeatedly appears at predetermined time intervals (so that the same pulse temporal waveform repeatedly appears at predetermined time intervals) at the converging position $P_1$ of the diffraction grating 16A. This phase control will be specifically described.

The phase control device 20A has a spectral phase measurement instrument (FROG et al., J. Paye et al., Opt. Lett. 18, 1946-1948 (1993)) 21A and a spectral phase modulator (for example, a 4f optical system composed of a diffraction grating and a liquid crystal spatial modulator, or an acousto-optic programmable dispersive filter, (P. Tournois et al., Opt. Commun. 140, 245-249 (1997)) 22A. Moreover, the laser device 1A is provided with a half mirror 23A for splitting a part of the multiplexed light $LA_3$ and a mirror 24A for leading the multiplexed light $LA_3$ split by the half mirror 23A to the spectral phase measurement instrument 21 A.

In such a phase control device 20A, the phase of each of the laser lights $LA_1$ is controlled as follows. That is, in the phase control device 20A, a part of the multiplexed light $LA_3$ is input to the spectral phase measurement instrument 21A by the half mirror 23A and the mirror 24A. The spectral phase measurement instrument 21A measures a spectral phase (phase changed between the position $P_0$ and the position $P_1$) of the input multiplexed light $LA_3$. More specifically, the spectral phase measurement instrument 21A measures the phase of each of the laser lights $LA_2$ contained in the input multiplexed light $LA_3$. Then, the spectral phase measurement instrument 21A sends (feeds back) information indicating the measurement result to the spectral phase modulator 22A. The spectral phase modulator 22A, based on the information indicating the measurement result from the spectral phase measurement instrument 21A, controls the phase of each of the laser lights $LA_1$ contained in the seed light $LA_0$ so that a peak in output of the multiplexed light $LA_3$ repeatedly appears at predetermined time intervals (so that the same pulse temporal waveform repeatedly appears at predetermined time intervals). In other words, the phase control device 20A measures a spectral phase of the multiplexed light $LA_3$ as well as controls the phase of each of the laser lights $LA_1$ based on the measurement result (and eventually controls the phase of each of the laser lights $LA_2$).

As a result of the phase control device 20A controlling the phases of the plurality of laser lights having different frequencies composing the seed light $LA_0$ (correcting by frequency a phase change added between the position $P_0$ and the position $P_1$) as such, the multiplexed light $LA_3$ to be generated by the diffraction grating 16A results in a pulsed laser light that is equivalent to optical frequency comb laser lights after mode-locked oscillation and increased in peak intensity.

In the laser device 1A configured in such a manner as above, first, a seed light $LA_0$ is oscillated from the laser light source 10A. The seed light $LA_0$ oscillated from the laser light source 10A passes through the spectral phase modulator 22A and the optical isolator 11A and reaches the diffraction grating 12A. The seed light $LA_0$ having reached the diffraction grating 12A is demultiplexed by frequency by the diffraction grating 12A into a plurality of laser lights $LA_1$. The phase of each of the laser lights $LA_1$ demultiplexed by the diffraction grating 12A is controlled by the spectral phase modulator 22A so that a multiplexed light $LA_3$ to be generated later results in a pulsed laser light. The respective laser lights $LA_1$ demultiplexed by the diffraction grating 12A travel parallel to each other as a result of passing through the lens 13A, and are made incident into the channel amplifier 14A. Each of the laser lights $LA_1$ made incident into the channel amplifier 14A is amplified in the channel amplifier 14A and emitted as a laser light $LA_2$.

Each of the laser lights $LA_2$ emitted from the channel amplifier 14A is converged onto the diffraction grating 16A by passing through the lens 15A. Then, the respective laser lights $LA_2$ converged onto the diffraction grating 16A are multiplexed with each other by the diffraction grating 16A, and output from the laser device 1A as a multiplexed light $LA_3$ being a pulsed laser light. A part of the multiplexed light $LA_3$ output at this time is input to the spectral phase measurement instrument 21 A, and used for measurement of a spectral phase.

As described above, in the laser device 1A according to the present embodiment, the channel amplifier 14A amplifies each of the plurality of laser lights $LA_1$ being continuous lights. Therefore, as compared with the case of amplifying a pulsed laser light, the amplification factor can be set high. Moreover, when generating the multiplexed light $LA_3$ by multiplexing the respective amplified laser lights $LA_2$ in the diffraction grating 16A, the phase of each of the laser lights $LA_1$ is controlled so that a peak in output of the multiplexed light $LA_3$ repeatedly appears at predetermined time intervals at the converging position $P_1$. A pulsed laser light is hence generated by the amplified plurality of laser lights $LA_2$ at the converging position $P_1$. Accordingly, by this laser device, a high-output pulsed laser light can be generated.

Moreover, in the laser device 1A, a seed light $LA_0$ being a laser pulse train is demultiplexed into laser lights $LA_1$ being continuous lights by the diffraction grating 12A, and after continuous light amplification by the channel amplifier 14A, the respective laser lights $LA_1$ are again converted into a laser pulse train by the diffraction grating 16A. Thus, because the laser device 1A performs continuous light amplification in the channel amplifier 14A, a nonlinear optical effect (for example, self-phase modulation, beam breakup, or the like) or a narrower bandwidth (an increase in pulse width) when amplifying a pulsed laser light does not occur. Therefore, by the laser device 1A, a pulsed laser light with high beam quality as well as having a high repetition rate and short pulses can be generated, as compared with that of a laser device that amplifies a pulsed laser light.

Moreover, in the laser device 1A, because the frequency difference between the laser lights contained in the seed light $LA_0$ is constant, it is easy to control the phase of each of the laser lights $LA_1$ so that a peak in output of the multiplexed light $LA_3$ repeatedly appears at predetermined time intervals.

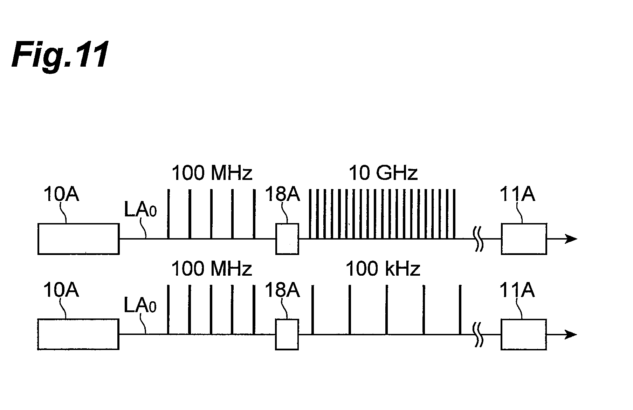

The laser device 1A can, as shown in Figs. 8 and 11, at a previous stage of the optical isolator 11A on the optical path of the seed light $LA_0$, further include a frequency modulator (frequency difference adjusting means) 18A. The frequency modulator 18A adjusts the frequency difference between the laser lights contained in the seed light $LA_0$. Accordingly, the frequency spacing between the laser lights contained in the seed light $LA_0$ (optical frequency comb spacing) can be made for example, integral times such as from 100MHz to 10GHz, and can be made an integral number-th part such as from 100MHz to 100kHz. Hence, the interval $\Delta x$ between the laser lights $LA_1$ spatially arrayed by being demultiplexed by the diffraction grating 12A can be arbitrarily adjusted. Moreover, the pulse repetition rate of the multiplexed light $LA_3$ can be made variable at the request of the application. The frequency modulator 18A may either be composed of a mirror pair or be an LN (lithium niobate) modulator. Further, for a higher repetition rate of the multiplexed light $LA_3$, a spectral phase modulator 22A that can modulate both the amplitude and phase may be used.

[Third embodiment]

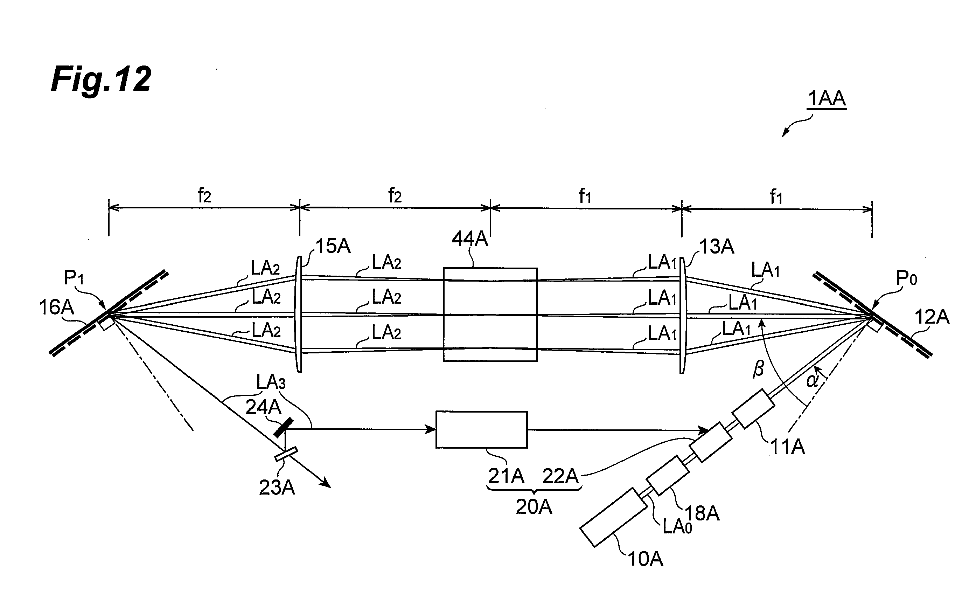

A laser device according to the present embodiment is different from the laser device 1A according to the second embodiment in the following point. That is, as shown in Fig. 12, the laser device 1AA according to the present embodiment includes a slab type solid-state laser amplifier 44A in place of the channel type amplifier 14A. In the laser device 1AA, the focal position of the lens 13A is made coincident with the focal position of the lens 15A, and the slab type solid-state laser amplifier 44A is disposed at that coincidence point.

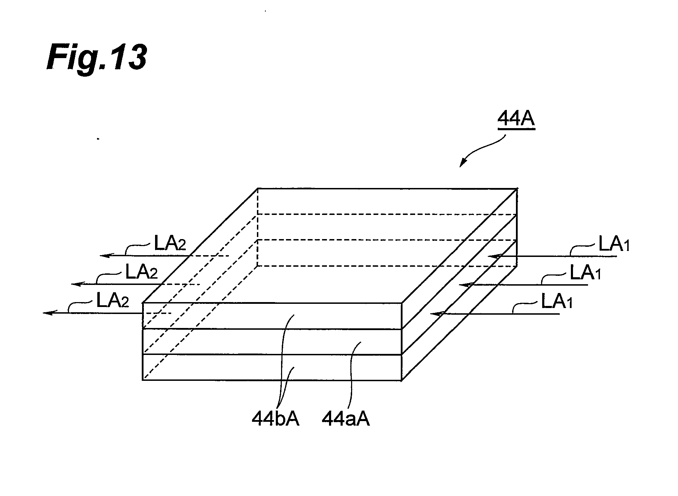

The slab type solid-state laser amplifier 44A has a structure in which, as shown in Fig. 13, a layer 44aA made of an amplifying medium (for example, a ceramic material and the like) doped with an active medium (for example, Nd, Yb, Er, Bi, Pr, and the like) is sandwiched with a pair of layers 44bA made of a non-doped ceramic material or a material lower in refractive index and higher in heat conductivity (for example, sapphire and the like) than the amplifying medium. Into such a slab type solid-state laser amplifier 44A, the respective laser lights $LA_1$ having frequencies different from each other are made incident with the intervals of $\Delta x$ described with reference to Fig. 4. Then, the slab type solid-state laser amplifier 44A amplifies each of the incident laser light $LA_1$ as a continuous light, and emits each of the amplified laser lights $LA_2$. In other words, the slab type solid-state laser amplifier 44A propagates while amplifying each of the laser lights $LA_1$ demultiplexed by the diffraction grating 12A. The slab type solid-state laser amplifier 44A may be composed solely of the layer 44aA made of an amplifying medium.

Also in the laser device 1AA including such a slab type solid-state laser amplifier 44A, similar to the laser device 1A according to the second embodiment, the respective laser lights $LA_2$ amplified and emitted by the slab type solid-state laser amplifier 44A are converged to the diffraction grating 16A and multiplexed after passing through the lens 15A. Therefore, also in this laser device 1AA, similar to the laser device 1A, a high-output pulsed laser light can be generated. Moreover, the laser device 1AA according to the present embodiment uses the slab type solid-state laser amplifier 44A as a means for amplifying laser lights $LA_1$, and can thus be favorably used even when a seed light $LA_0$ having a relatively low repetition frequency such as 1kHz to a few hundreds of kHz is used.

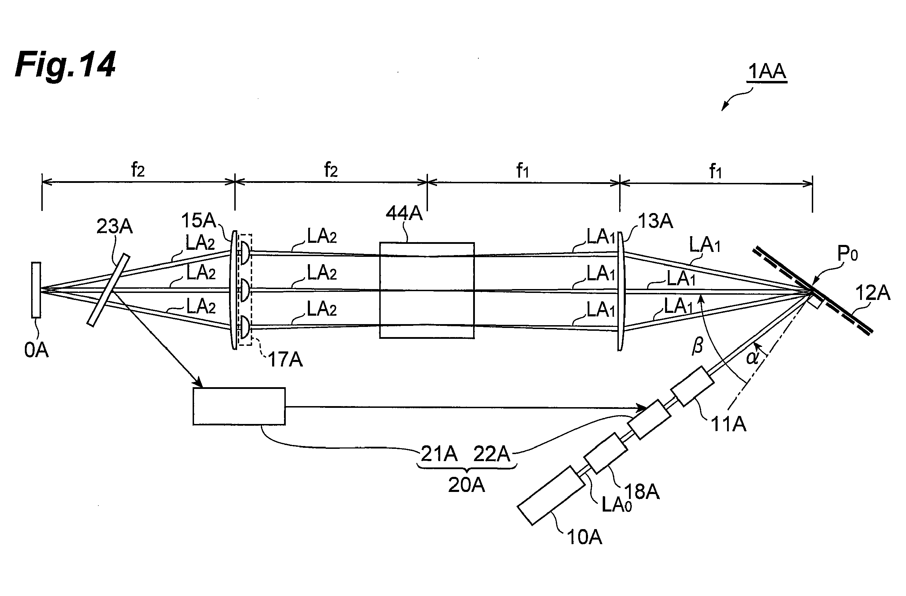

Although the laser device 1AA is configured so as to generate a multiplexed light $LA_3$ by multiplexing respective laser lights $LA_2$ by the diffraction grating 16A, when it is not necessary to transmit a multiplexed light $LA_3$, for example, as shown in Fig. 14, there may be a configuration of directly converging respective laser lights $LA_2$ onto a processing object OA without using the diffraction grating 16A, and generating a multiplexed light $LA_3$ at that position. In this case, the size of a converging spot on the processing object OA can be adjusted by disposing a multi-lens array 17A of convex lenses or concave lenses on the side of a light incident surface of the lens 15A on the optical path of the laser light $LA_2$, and adjusting the focal length of the multi-lens array 17A.

Moreover, in this case, a half mirror 23A may be disposed at a subsequent stage of the lens 15A to make a part of each of the laser lights $LA_2$ split and incident into the spectral phase measurement instrument 21A. Therefore, in this case, the phase control device 20A measures the phase of each of the laser lights $LA_2$ as well as controls the phase of each of the laser lights $LA_1$ based on the measurement result.

Further, in terms of whether to use the channel type amplifier 14A or the slab type solid-state laser amplifier 44A as an amplifier for laser lights $LA_1$ or what kind of active medium to use and the like, optimal options can be selected depending on a desired laser center wavelength, output power, and the like.

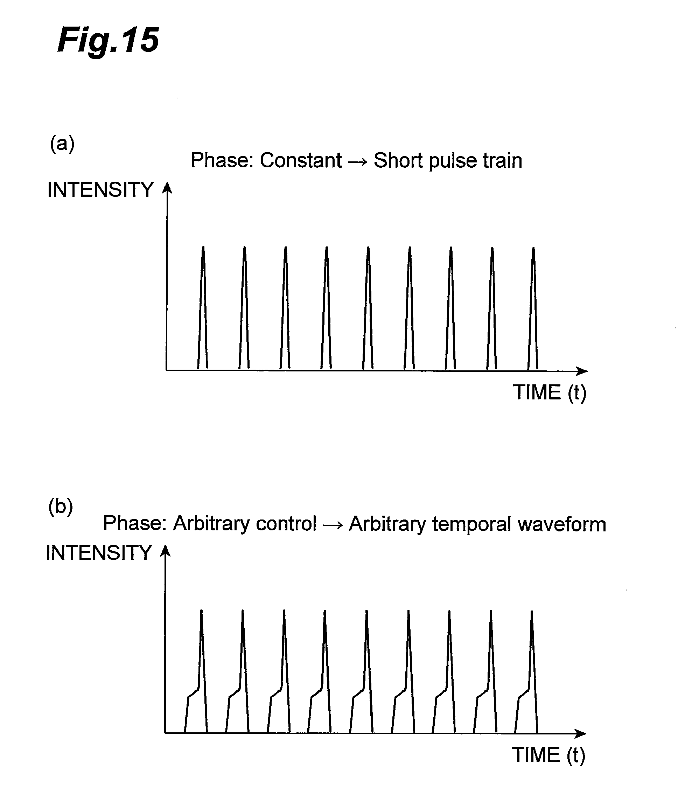

In the laser devices 1A, 1AA according to the second and third embodiments described above, the phases of the respective laser lights $LA_2$ being amplified lights of the laser lights $LA_1$ having frequencies different from each other can either be controlled so as to be coincident with each other or be controlled so as to have values different from each other. Because the pulse temporal waveform and the spectral phase distribution are in the relationship of a complex Fourier transform, by adjusting the phases of the respective laser lights $LA_2$ being amplified lights of the laser lights $LA_1$ having frequencies different from each other by means of the phase control device 20A (that is, by means of the spectral phase modulator 22A), an arbitrary pulse output waveform can be obtained in the multiplexed light $LA_3$, as shown in Fig. 15. In other words, in the laser devices 1A, 1AA, by controlling the phases of the laser lights $LA_1$ (laser lights $LA_2$) having frequencies different from each other, the temporal waveforms of laser pulses to be generated can be variously controlled.

Moreover, in such a case where the peak intensity of the multiplexed light $LA_3$ exceeds a damage threshold of the diffraction grating 16A in the laser devices 1A, 1AA according to the second and third embodiments, the peak intensity of the multiplexed light $LA_3$ on the diffraction grating 16A may also be lowered by increasing the focal length $f_2$ of the lens 15A to be a few times longer than the focal length $f_1$ of the lens 13A.

Further, in the laser devices 1A, 1AA according to the second and third embodiments, a mode-locked oscillator or a semiconductor laser for a high-speed current modulation can be used as the laser light source 10A. In this case, a small-sized and lightweight laser device with low power consumption can be realized. Moreover, the mechanical stability of the laser device can be improved. Furthermore, the manufacturing cost of the laser device can be reduced.

A laser device according to the present embodiment can include an oscillating means for multiplying and oscillating a plurality of laser lights being continuous lights and having frequencies different from each other, a demultiplexing means for demultiplexing by frequency the laser lights oscillated from the oscillating means, an amplifying means for amplifying each of the laser lights demultiplexed by the demultiplexing means, a multiplexing means for multiplexing the respective laser lights amplified by the amplifying means at a predetermined position to generate a multiplexed light, and a phase control means for controlling the phase of each of the laser lights so that a peak in output of the multiplexed light repeatedly appears at predetermined time intervals at the predetermined position. In that case, the oscillating means can multiply and oscillate the laser lights having frequencies different from each other with substantially constant frequency differences. Moreover, the laser device according to the present embodiment can further include a frequency difference adjusting means for adjusting a frequency difference between the laser lights oscillated from the oscillating means. Moreover, the oscillating means can be a semiconductor laser. Moreover, the amplifying means is a fiber array containing a plurality of optical fibers that propagate while amplifying each of the laser lights demultiplexed by the demultiplexing means, and the phase control means controls the phase of each of the laser lights by controlling the temperature of each of the optical fibers.

**Industrial Applicability**

The present invention can provide a laser device capable of easily generating a short-pulse and high-output pulsed laser light and a laser device capable of generating a high-output pulsed laser light.

**Reference Signs List**

1: laser device, 10: laser light source (oscillating means), 11: optical fiber, 12: lens (multiplexing means), 13: diffraction grating

(multiplexing means), 20: phase control device (phase control means) $L_1$: laser light, $L_2$: multiplexed light, 1A, 1AA: laser device , 10A: laser light source (oscillating means), 12A: diffraction grating (demultiplexing means), 14A: channel amplifier (amplifying means), 14aA: optical fiber, 15A: lens (multiplexing means), 16A: diffraction grating (multiplexing means), 18A: frequency modulator (frequency difference adjusting means), 20A: phase control device (phase control means), 44A: slab type solid-state laser amplifier (amplifying means), $LA_0$: seed light (laser pulse train), $LA_1$, $LA_2$: laser light (continuous laser light), $LA_3$: multiplexed light.

**Claims**

1.  A laser device comprising:

    oscillating means for oscillating a laser pulse train consisting of a plurality of continuous laser lights having frequencies different from each other;
    demultiplexing means for demultiplexing the laser pulse train oscillated from the oscillating means into the plurality of continuous laser lights having frequencies different from each other;
    amplifying means for amplifying each of the continuous laser lights demultiplexed by the demultiplexing means;
    multiplexing means for multiplexing the respective continuous laser lights amplified by the amplifying means at a predetermined position to generate a multiplexed light; and
    phase control means for controlling the phase of each of the continuous laser lights so that a peak in output of the multiplexed light repeatedly appears at predetermined time intervals at the predetermined position.

2.  The laser device according to claim 1, wherein the oscillating means oscillates the laser pulse train consisting of the continuous laser lights having frequencies different from each other with substantially constant frequency differences.

3.  The laser device according to claim 2, further comprising frequency difference adjusting means for adjusting a frequency difference between the continuous laser lights composing the laser pulse train oscillated from the oscillating means.

4.  The laser device according to any one of claims 1 to 3, wherein the oscillating means is a mode-locked oscillator or a semiconductor laser for a high-speed current modulation.

5.  The laser device according to any one of claims 1 to 4, wherein the amplifying means is a fiber array containing a plurality of optical fibers or a slab type solid-state laser amplifier, which propagates while amplifying each of the continuous laser lights demultiplexed by the demultiplexing means, and
    the phase control means measures a spectral phase of the multiplexed light as well as controls the phase of each of the continuous laser lights based on a result of the measurement.

*Fig.1*

Fig.2

Fig.3

EP 2 945 012 A1

# Fig.4

(a)

11

BB

H

(b)

H

PL

11

## Fig.5

EP 2 945 012 A1

**Fig.6**

# *Fig.7*

AMPLITUDE

$\Delta \nu = c/2L = 1/T$

$\nu$ [Hz]

*Fig.8*

# Fig.9

**Fig.10**

14A

14aA

14aA

Δx

14aA

14bA

14aA

Fig.11

EP 2 945 012 A1

# Fig.12

## Fig.13

# Fig.14

EP 2 945 012 A1

# Fig.15

(a)

Phase: Constant → Short pulse train

(b)

Phase: Arbitrary control → Arbitrary temporal waveform

Europäisches
Patentamt

European
Patent Office

Office européen
des brevets

# EUROPEAN SEARCH REPORT

Application Number

EP 15 17 4389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/128554 A1 (WICKHAM MICHAEL G [US] ET AL) 16 June 2005 (2005-06-16) | 1-5 | INV. G02F1/01 H01S5/40 H01S5/068 H01S3/13 H01S3/23 |
| Y | * paragraphs [0014] - [0022]; figures 1-6 * | 3 | |
| Y | US 2005/018724 A1 (DA SILVA CLAUDIO FERNANDES CAS [BR] ET AL) 27 January 2005 (2005-01-27) * paragraphs [0035] - [0038]; figure 1 * | 3 | ADD. H01S3/11 H01S5/12 H01S3/00 H01S5/00 H01S3/067 H01S3/06 |

TECHNICAL FIELDS
SEARCHED    (IPC)

H01S

The present search report has been drawn up for all claims

| Place of search | Date of completion of the search | Examiner |
|---|---|---|
| Munich | 1 October 2015 | Laenen, Robert |

**ANNEX TO THE EUROPEAN SEARCH REPORT
ON EUROPEAN PATENT APPLICATION NO.** EP 15 17 4389

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2015

| Patent document cited in search report | | Publication date | Patent family member(s) | | Publication date |
|---|---|---|---|---|---|
| US 2005128554 | A1 | 16-06-2005 | EP 1692748 A2<br>JP 2007514305 A<br>US 2005128554 A1<br>WO 2005062090 A2 | | 23-08-2006<br>31-05-2007<br>16-06-2005<br>07-07-2005 |
| US 2005018724 | A1 | 27-01-2005 | AU 2002310612 A1<br>EP 1413025 A2<br>GB 2381121 A<br>US 2005018724 A1<br>WO 02099939 A2 | | 16-12-2002<br>28-04-2004<br>23-04-2003<br>27-01-2005<br>12-12-2002 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0690050 B

**Non-patent literature cited in the description**

- *Opt. Laser Technol.,* 2004, vol. 37, 29-32
- **FROG et al.** *J. Paye et al., Opt. Lett.,* 1993, vol. 18, 1946-1948
- **P. TOURNOIS et al.** *Opt. Commun.,* 1997, vol. 140, 245-249